# Europäisches Patentamt
# European Patent Office
# Office européen des brevets

(19)

(11) Veröffentlichungsnummer: **0 092 540**
**B1**

(12)

# EUROPÄISCHE PATENTSCHRIFT

(45) Veröffentlichungstag der Patentschrift:
04.11.87

(51) Int. Cl.⁴: **H 01 L 21/322**, H 01 L 31/18

(21) Anmeldenummer: **83890053.8**

(22) Anmeldetag: **05.04.83**

(54) **Verfahren zum Gettern von Halbleiterbauelementen.**

(30) Priorität: **06.04.82 AT 1366/82**

(43) Veröffentlichungstag der Anmeldung:
**26.10.83 Patentblatt 83/43**

(45) Bekanntmachung des Hinweises auf die Patenterteilung:
**04.11.87 Patentblatt 87/45**

(84) Benannte Vertragsstaaten:
**BE CH DE FR GB IT LI LU NL SE**

(56) Entgegenhaltungen:
**DD-A-145 144**
**DE-A-1 816 063**
**DE-A-2 738 195**
**US-A-3 701 696**

**IBM TECHNICAL DISCLOSURE BULLETIN, Band 20,**
**Nr. 9, Februar 1978, New York M.R. POPONIAK et**
**al. "Impurity gettering and removing gettered**
**impurities" Seiten 3454-3455**
**IEEE TRANSACTIONS ON ELECTRON DEVICES,**
**Band ED-27, Nr. 4, April 1980, New York T. SAITOH**
**et al. "Impurity gettering of polycrystalline solar**
**cells fabricated from refined metallurgical-grade**
**silicon", Seiten 671-677**
**IEEE Transactions on Electron Devices, Vol.ED-27,**
**No.4, April 1980, S. 671-677**

(73) Patentinhaber: **Shell Austria Aktiengesellschaft,
Rennweg 12, A-1030 Wien (AT)**

(72) Erfinder: **Schlosser, Viktor, Dr., Linzerstrasse
284A/13, A-1140 Wien (AT)**

(74) Vertreter: **Pfeifer, Otto, Dipl.- Ing., Patentanwälte
Dipl.- Ing. Dr. techn. Schütz, Alfred Dr. phil.
Mrazek, Engelbert Dipl.- Ing. Holzer, Walter
Dipl.- Ing. Pfeifer, Otto Fleischmanngasse 9,
A-1040 Wien (AT)**

## Beschreibung

Die vorliegende Erfindung bezieht sich auf ein Verfahren zum Gettern von Halbleiterbauelementen, insbesondere von Siliziumhalbleiterbauelementen.

Unter Gettern versteht man in der Halbleitertechnologie das nachträgliche Entfernen von störenden Verunreinigungen aus halbfertigen oder fertigen Halbleiterbauelementen.

Bekannte Methoden zum Gettern von auf kristallinem Silizium basierenden Bauelementen sind beispielsweise das Aufbringen von $P_2O_5$, $B_2O_3$ und ähnlichen Glasoxiden auf die aktive Region des Bauelementes, die Erzeugung stark gestörter Oberflächen auf der Rückseite des Bauelementes, z. B. durch Ionenbeschuß oder mechanisches Aufrauhen, die Anordnung von Nitridschichten auf der Rückseite des Bauelementes oder ein Hochtemperatur-Tempern in einer Stickstoffatmosphäre. Das Gettern wirkt sich dahin aus, daß störende Fremdatome, insbesondere Schwermetalle, in der aktiven Zone des Bauelementes bevorzugt in die Getterschicht diffundieren, die anschließend entfernt wird, so daß im Bauelement weniger Störstellen zurückbleiben. Kristalldefekte werden durch das Herausdiffundieren von Silizium- und/oder Fremdatomen und die anschließende Neuordnung des Siliziumkristallgitters elektronisch inaktiv gemacht. Meistens stellt sich der Getterprozeß als eine Kombination dieser beiden Vorgänge dar. Aus der DE-A-1 816 083 ist weiterhin ein Verfahren zum Gettern von Halbleiterbauelementen, insbesondere von Siliziumhalbleiterbauelementen, bekannt, bei dem eine Getterschicht, die aus amorphem oder mikrokristallinem Silizium bestehen kann, auf die Rückseite des Bauelementes aufgebracht wird und anschließend eine thermische Behandlung des beschichteten Bauelementes erfolgt.

Die bekannten Gettermethoden weisen neben einer Reihe von Vorteilen auch einige erhebliche Nachteile auf. So wirkt bei der erstgenannten Methode (Aufbringen von $P_2O_5$, $B_2O_3$ und ähnlichen Glasoxyden auf die aktive Region des Bauelementes) die Getterschicht zwar unmittelbar auf die aktive Zone des Bauelementes und ermöglicht die Erzielung einer hohen Getterwirkung bei kurzer Getterdauer von etwa 1 h, anderseits geben diese Gettermaterialien unerwünschte Fremdstoffe an die Siliziumschicht ab. Überdies ist die Getterschicht teilweise nur schwer entfernbar. Bei der Erzeugung stark gestörter Oberflächen auf der Rückseite des Bauelementes werden zwar die elektronischen Eigenschaften nicht beeinflußt, weil keine Fremdatome vorhanden sind, auch kann die Getterschicht leicht wiederum entfernt werden; das Gettern erfolgt jedoch bei dieser Methode von der Rückseite aus durch das gesamte Basismaterial. Um daher die aktive Schicht zu verbessern, sind lange Getterzeiten erforderlich (6 h bis 24 h). Das Aufbringen von Nitridschichten auf der Rückseite des Bauelementes hat den Vorteil eines geringen Einflusses des Stickstoffes als Verunreinigung, zeigt aber den gleichen Nachteil wie die zuvor beschriebene Methode, insbesondere die langen Getterzeiten. Auch beim Hochtemperatur-Tempern des Siliziumhalbleiterbauelementes in einer Stickstoffatmosphäre ist der geringe Einfluß des Stickstoffes als Verunreinigung von Vorteil, doch sind lange Getterzeiten und hohe Temperaturen erforderlich, weil die umgebende Gasatmosphäre als Getter geringer Dichte wirkt.

Allen bisher bekannten Getterverfahren haften somit erhebliche Mängel an, wie Abgabe störender Verunreinigungen in die aktive Region des Bauelementes und lange Getterzeiten bei erhöhter Temperatur, die ein Verfließen von Dotierungsprofilen im Bauelement verursachen und es folglich unbrauchbar machen.

Es besteht somit nach wie vor ein Bedarf nach Verfahren zum Gettern von Halbleiterbauelementen, insbesondere auf Siliziumbasis, die die vorstehend aufgezeigten Nachteile der bekannten Methoden nicht aufweisen, möglichst einfach ausführbar sind und in kurzer Zeit eine weitgehende Entfernung von störenden Verunreinigungen aus fertigen oder halbfertigen-Halbleiterbauelementen ergeben.

Es wurde nun gefunden, daß diese Ziele durch ein neues Verfahren zum Gettern von Halbleiterbauelementen, insbesondere von Siliziumhalbleiterbauelementen, erreicht werden können, das keinen Einbau von störenden Fremdatomen mit sich bringt, direkt auf die aktive Schicht einwirkt und nach kurzen Getterzeiten ein leichtes Entfernen der Getterschicht ermöglicht.

Gegenstand der vorliegenden Erfindung ist somit ein Verfahren zum Gettern von Halbleiterbauelementen, insbesondere von Siliziumhalbleiterbauelementen, bei welchem auf die Vorderseite des Bauelementes amorphes oder mikrokristallines Silizium als Getterschicht aufgebracht, das beschichtete Bauelement einer thermischen Behandlung unterzogen und schließlich die Getterschicht entfernt wird.

Der erste Schritt des erfindungsgemäßen Verfahrens, das Aufbringen von amorphem/mikrokristallinem Silizium, vorzugsweise mit Schichtdicken von eingen 10 nm (einigen 100 Å) bis 10 μm, auf ein Halbleiterbauelement, z. B. eine Solarzelle, kann nach den folgenden, beispielsweise angeführten Methoden erfolgen:

1) Abscheiden aus der Dampfphase durch thermische Zersetzung von geeigneten Siliziumverbindungen (z. B. $SiCl_4$, $SiHCl_3$)

2) Abscheiden aus der Dampfphase durch Zersetzung geeigneter Siliziumverbindungen (z. B. $SiH_4$) mittels Glimmentladung

3) Thermisches Verdampfen von Silizium

4) Elektronenstrahlverdampfen von Silizium

5) Sputtern mittels Siliziumtargets

6) Abscheiden einer kristallinen (ein- oder polykristallinen) Siliziumschicht mittels geeigneter Verfahren und anschließendes Zerstören dieser Schicht mittels Ionen oder Elektronenbeschuß (Transformation in amorphes/mikrokristallines Silizium).

Gemäß einer besonders vorteilhaften Ausführungsform des erfindungsgemäßen Verfahrens kann die Getterwirkung des amorphen oder mikrokristallinen Siliziums dadurch erheblich verbessert werden, daß vor der Ausführung des zweiten Schrittes des Gesamtverfahrens, der thermischen Behandlung des beschichteten Bauelementes, mindestens eine weitere dünne dielektrische Schicht auf das amorphe oder mikrokristalline Silizium abgeschieden wird. Hiebei werden vor Beginn der thermischen Behandlung eine oder mehrere dünne dielektrische Schichten (3 nm (30 Å) bis 3 µm) aufgebracht.

Infolge verschiedener thermischer Ausdehnungskoeffizienten von kristallinem Silizium und Dielektrikum entstehen Spannungen im kristallinen Silizium, die den Aufbau des Kristallgitters derart beeinflussen, daß störende Fremdatome sich leichter (d.h. schneller) im Kristallgitter bewegen können. Überdies erfolgt eine Änderung der atomaren Zusammensetzung des amorphen Siliziums unter der dielektrischen Schicht, als deren Folge Störatome, die aus dem Siliziumkristall in die Schicht aus amorphem Silizium diffundiert sind, hierin besonders leicht und effektiv gebunden werden können (z. B. kann aus der dielektrischen Schicht Sauerstoff in die Schicht aus amorphem Silizium diffundieren und hier eine Oxidbildung des Störatoms verursachen).

Als Folge eines derartigen Verhaltens kann eine höhere Sättigungskonzentration des Fremdatoms in der Schicht aus amorphem Silizium erreicht und das Rückdiffundieren der gegetterten Störatome vermindert werden.

Als Material für die erfindungsgemäß aufgebrachte(n) weitere(n) dünne(n) dielektrische(n) Schicht(en) eignet sich insbesondere $SiO_x$, wobei $1 \leqslant x \leqslant 2$, aber auch $Al_2O_3$, $Si_3N_4$, $ZrSi_2$ oder $TiSi_2$ oder $MgO$, $BeO$, $ZrO_2$ bzw. $TiO_2$, die nach einer der folgenden, beispielhaft angeführten Methoden auf das amorphe Silizium/mikrokristalline Silizium aufgebracht werden können:

1) Abscheiden aus einer Dampfphase geeigneter chemischer Stoffe, deren Reaktionsprodukt sich auf dem amorphen Silizium/mikrokristallinen Silizium niederschlägt (z. B.: $SiH_4$ und $O_2$ zur Bildung von $SiO_x$; $Al$, $HCl$, $CO_2$, $H_2$ für $Al_2O_3$; $SiCl_4$ und $NH_3$ für $Si_3N_4$, $SiCl_3$ oder $SiHCl_3$ und $ZrCl_4$ bzw. $TiOl_4$ und $H_2$ für $ZrSi_2$ bzw. $TiSi_2$ und $HCl$-$MgCl_2$-$CO_2$-$H_2$ für $MgO$)

2) ein Verfahren wie unter 1) beschrieben, jedoch mit Unterstützung einer Glimmentladung

3) Thermisches Verdampfen der Materialien

4) Elektronenstrahlverdampfen der Materialien

5) Sputtern mittels geeigneter Targets

6) Reaktives Sputtern in einer geeigneten Gasatmosphäre (z. B. Sputtern von Si in einer

definierten $O_2$-Atmosphäre).

Nach dem Aufbringen der zusätzlichen dielektrischen Schicht(en) wird der zweite Schritt des Gesamtverfahrens, die thermische Behandlung des beschichteten Bauelementes, ausgeführt. Diese thermische Behandlung erfolgt vorteilhaft in der Weise, daß das Bauelement in einer geeigneten Gasatmosphäre, z. B. in $H_2$, $N_2$, Edelgasen, oder im Vakuum einige Zeit lang, z. B. von 10 min bis 6 h, auf eine geeignete Temperatur von z. B. 200 bis 1200° C, vorzugsweise von 600 bis 900° C, aufgeheizt wird.

Der dritte und abschließende Schritt des erfindungsgemäßen Gesamtverfahrens, das Entfernen der Getterschicht, kann zweckmäßig nach einer der folgenden Methoden erfolgen:

1) Abtragen der Schicht mittels einer Kombination von Säuren (z. B. $HNO_3$ und $HF$ in einem günstigen Verhältnis und mit Wasser verdünnt)

2) Abtragen der Schicht durch Einwirkenlassen einer geeigneten Gasatmosphäre, z. B. $HCl$-Dampf, mit $H_2$-Gas verdünnt, bei einer Temperatur von 1275° C

3) Abtragen der Schicht durch Ionenätzen (Trockenätzen) geeigneter Ionen

4) Mechanisches Abtragen mittels geeigneter Schleif- und Läppmittel (z. B. $Al_2O_3$-Pulver).

Vor Ausführung des dritten und abschließenden Schrittes des Gesamtverfahrens, dem Entfernen der Getterschicht, oder je nach der angewendeten Methode auch in einem Arbeitsgang hiemit, wird bzw. werden die fakultative(n) zusätzliche(n) dielektrische(n) Schicht(en) entfernt, wobei sich das Abtragen der Getterschicht durch Einwirkenlassen einer geeigneten Gasatmosphäre bzw. das Abtragen der Getterschicht durch Ionenätzen (Trockenätzen) auch für die Entfernung der erfindungsgemäß zusätzlich aufgebrachten Materialien eignen. Bei einem Abtragen der Getterschicht mit Hilfe eines Säurengemisches kann es erforderlich sein, vor dem Abtragen des amorphen Siliziums/mikrokristallinen Siliziums die zusätzliche(n) dielektrische(n) Schicht(en) mit einer spezifischen Ätzlösung, z. B. einer Kombination von $NH_4F$, $NH_4OH$ und $HF$, mit Wasser verdünnt, für $SiO_x$ oder $Al_2O_3$, bzw. $H_3PO_4$ für $Si_3N_4$, zu entfernen. Eine weitere geeignete Methode besteht darin, alle Schichten mittels eines geeigneten Schleif- und Läppverfahrens mechanisch abzutragen.

Das erfindungsgemäße Verfahren eignet sich in hervorragender Weise zum Gettern von Siliziumsolarzellen. Diese bestehen aus drei Komponenten:

A) Substrat: Als Material kommen insbesondere polykristallines Ferrosilizium (metallurgisches Silizium), Rohsilizium, polykristalline Silizium-Substratscheiben (z. B. SILSO) oder einkristalline Silizium-Substratscheiben in Betracht. Im Falle des Ferrosiliziums ist das Substrat nicht Teil der aktiven Region der Solarzelle, jedoch beeinflussen Störatome, die während der Herstellung der Zelle in die aktive Region diffundieren, die aktive Region negativ. Das Substrat dient dem epitaktischen Aufwachsen der aktiven Region(en).

B) p-Si Schicht: Dicke 5 - 50 µm, hergestellt durch thermische Zersetzung von Trichlorsilan. Diese Schicht, die durch Borbeimengung p-leitend ist, wächst auf dem Substrat epitaktisch auf. Diese Schicht ist aktive Region der Solarzelle.

C) n-Si Schicht: Dicke 0,5 - 5 µm, gleichfalls hergestellt durch thermische Zersetzung von Trichlorsilan. Diese Schicht ist durch Phosphorbeimengung n-leitend und wächst auf der Komponente B) epitaktisch auf. Diese Schicht ist aktive Region der Solarzelle.

Die n-Schicht kann auch durch Phosphordiffusion in die Komponente B) ausgebildet werden.

Das erfindungsgemäße Verfahren, angewendet auf das Gettern von Siliziumsolarzellen, besteht in einer praktischen Ausführungsform darin, daß auf die Komponente(n) A) und/oder B) und/oder C) eine amorphe bzw. mikrokristalline Si-Schicht als Getterschicht aufgebracht wird, z. B. durch thermisches Zersetzen von Trichlorsilan bei geeigneten Herstellungsparametern, gegebenenfalls anschließend eine oder mehrere dünne dielektrische Schichten eines geeigneten Materials aufgebracht werden, hierauf die Getterschicht und die fakultative(n) zusätzliche(n) dielektrische(n) dünne(n) Schicht(en) in Wasserstoffgas 10 bis 180 min, vorzugsweise 10 bis 120 min, bei Temperaturen von 600° C is 950° C getempert werden und nachfolgend wieder entfernt werden. Dabei werden Störatome aus dem Substrat (Komponente A) entfernt, so daß diese nicht mehr in die aktive(n) Schicht(en) (Komponenten B) bzw. C)) eindiffundieren können, bzw. werden Störatome aus der bzw. den aktiven Schicht(en) entfernt.

Das Entfernen der Störstellen führt in einer erfindungsgemäß behandelten Solarzelle zu einer höheren Ausbeute von durch Licht freigesetzten Ladungsträgern (Vergrößerung der Diffusionslänge durch Abwesenheit von Rekombinationszentren) und zu einem besseren elektrischen Verhalten der Diode (des pn-Überganges), was eine effektivere Trennung der generierten Ladungsträger zur Folge hat. Es kann somit mehr elektrische Energie aus dem einfallenden Licht gewonnen werden. Insgesamt wird ein höherer Wirkungsgrad der Solarzelle erreicht.

Der Vorteil eines Aufbringens einer oder mehrerer dielektrischer Schichten gegenüber einem Gettern mit amorphem Silizium/mikrokristallinem Silizium allein liegt darin, daß eine erheblich größere Anzahl von Störatomen bei gleichen Temperbedingungen gegettert werden können. Das hat insbesondere zur Folge, daß die Diffusionslänge der Minoritätsladungsträger wesentlich vergrößert werden kann. Da die Zellenausbeute ursächlich von der Diffusionslänge abhängt, resultiert aus einer größeren Diffusionslänge ein höherer Wirkungsgrad der Solarzelle.

Das erfindungsgemäße Verfahren kann mit Vorteil auch für weitere Bauelemente angewendet werden, beispielsweise für solche Bauelemente (z. B. IC, LSI), die mittels Heteroepitaxie auf anderen Substraten als Silizium (z. B. $Al_2O_3$) hergestellt werden. Ferner eignet sich das erfindungsgemäße Verfahren auch zur Anwendung auf Bauelemente (z. B. VLSI) mit Strukturen im Bereich von 1 µm, um bei der Herstellung die Ausschußquote zu reduzieren.

Ferner kann das erfindungsgemäße Verfahren vorteilhaft auch für die Herstellung von Bauelementen angewendet werden, wo entweder die Getterdauer bei erhöhten Temperaturen möglichst kurz sein soll oder das Eindiffundieren von Fremdatomen aus dem Gettermaterial in den Si-Kristall unerwünscht ist. Insbesondere seien folgende mögliche Anwendungen angeführt:

Herstellung bipolarer IC-Schaltungen auf unreinem Silizium, substrat (einkristallines, versetzungsfreies Ferrosilizium).

Der Vorteil des erfindungsgemäßen neuen Verfahrens zum Gettern von Halbleiterbauelementen liegt bei den vorstehend erwähnten Anwendungsmöglichkeiten darin, daß andere Getterverfahren herstellungsbedingt nicht möglich sind (z. B. Gettern durch stark gestörte Oberflächen auf der Rückseite des Bauelementes bei Verwendung von anderen Substraten als Silizium-Substraten) oder durch die Dimensionierung der Bauelementstruktur nur, sofern überhaupt möglich, mit erheblichem technologischen Aufwand ausgeführt werden können (z. B. Gettern mit $P_2O_5$ auf Bauelementen mit Strukturen von 1 µm, wo die unerwünschte Diffusion der Dotierstoffe während des Getterns besonders kritisch ist).

## Patentansprüche

1. Verfahren zum Gettern von Halbleiterbauelementen, insbesondere von Siliziumhalbleiterbauelementen, das die Kombination der folgenden Schritte umfaßt:

a. Aufbringen einer Getterschicht aus amorphem oder mikrokristallinem Silizium auf die Vorderseite des Bauelementes, gegebenenfalls Aufbringen einer oder mehrerer dünner dielektrischer Schichten (3 nm - 3 µm) auf die Getterschicht,

b. thermische Behandlung des beschichteten Bauelementes und

c. Entfernen der Getterschicht, gegebenenfalls zusammen mit der bzw. den dielektrischen Schicht(en).

2. Verfahren nach Anspruch 1, dadurch gekennzeichnet, daß im ersten Schritt amorphes oder mikrokristallines Silizium in einer Schichtdichte von einigen 10 nm bis 10 µm

aufgebracht wird.

3. Verfahren nach Anspruch 1 oder 2, dadurch gekennzeichnet, daß das Aufbringen von amorphem oder mikrokristallinem Silizium durch Abscheiden aus der Dampfphase über die thermische Zersetzung von Siliziumverbindungen erfolgt.

4. Verfahren nach einem der Ansprüche 1 bis 3, dadurch gekennzeichnet, daß auf die Getterschicht aus amorphem oder mikrokristallinem Silizium eine oder mehrere dielektrische Schicht(en) aus $SiO_x$, wobei $1 \leqslant x \leqslant 2$ ist, aufgebracht wird bzw. werden.

5. Verfahren nach einem der Ansprüche 1 bis 3, dadurch gekennzeichnet, daß auf die Getterschicht aus amorphem oder mikrokristallinem Silizium eine oder mehrere dielektrische Schicht(en) aus $Al_2O_3$ aufgebracht wird bzw. werden.

6. Verfahren nach einem der Ansprüche 1 bis 3, dadurch gekennzeichnet, daß auf die Getterschicht aus amorphem oder mikrokristallinem Silizium eine oder mehrere dielektrische Schicht(en) aus $Si_3N_4$ aufgebracht wird bzw. werden.

7. Verfahren nach einem der Ansprüche 1 bis 3, dadurch gekennzeichnet, daß auf die Getterschicht aus amorphem oder mikrokristallinem Silizium eine oder mehrere dielektrische Schicht(en) aus MgO, BeO, $ZrO_2$ bzw. $TiO_2$ aufgebracht wird bzw. werden.

8. Verfahren nach einem der Ansprüche 1 bis 7, dadurch gekennzeichnet, daß im zweiten Schritt das Bauelement in einer geeigneten Gasatmosphäre, insbesondere in $H_2$, $N_2$ oder in Edelgasen, oder im Vakuum einige Zeit lang, insbesondere von 10 min bis 6 h, auf eine geeignete Temperatur von z. B. 200 bis 1200° C, vorzugsweise von 600 bis 900° C, aufgeheizt wird.

9. Verfahren nach einem der Ansprüche 1 bis 8, dadurch gekennzeichnet, daß im dritten Schritt die dielektrische Schicht und die Getterschicht gleichzeitig durch Einwirkenlassen einer geeigneten Gasatmosphäre abgetragen werden.

10. Verfahren nach einem der Ansprüche 1 bis 8, dadurch gekennzeichnet, daß zunächst die dielektrische Schicht unter Einwirkung einer spezifischen Ätzlösung entfernt und hierauf die Getterschicht mit einem Säurengemisch abgetragen wird.

11. Verfahren nach einem der Ansprüche 1 bis 10, dadurch gekennzeichnet, daß beim Gettern von Siliziumsolarzellen auf die Vorderseite des Siliziumsubstrats und/oder auf die p-leitende Siliziumschicht und/oder auf die n-leitende Siliziumschicht die amorphe bzw. mikrokristalline Siliziumgetterschicht aufgebracht wird, anschließend eine dünne dielektrische Schicht niedergeschlagen wird, hierauf das beschichtete Bauelement der thermischen Behandlung unterzogen wird und schließlich die dielektrische Schicht und die Getterschicht entfernt werden.

12. Verfahren nach Anspruch 11, dadurch gekennzeichnet, daß durch thermisches Zersetzen von Trichlorsilan eine amorphe bzw. mikrokristalline Siliziumschicht aufgebracht wird, anschließend eine dünne dielektrische Schicht aus $SiO_x$ niedergeschlagen wird, hierauf die Struktur in Wasserstoffgas 10 bis 120 min bei Temperaturen von 600° C bis 950° C getempert wird und schließlich die dielektrische Schicht und die Getterschicht entfernt werden.

## Claims

1. Process for gettering semiconductor devices, particularly silicon semiconductor devices, which process comprises the combination of the following steps:

a. applying a getter layer of amorphous or microcrystalline silicon onto the front face of the device; possibly applying one or a plurality of thin dielectric layers (3 nm - 3 μ) onto the getter layer;

b. thermally treating the coated device; and

c. removing the getter layer, possibly together with the dielectric layer(s).

2. Process according to claim 1, characterized in that amorphous or microcrystalline silicon is applied in the first stage in a layer thickness of several 10 nm tto 10 μ.

3. Process according to claim 1 or 2, characterized in that the application of amorphous or microcrystalline silicon is effected by deposition from the vapor phase by way of thermal decomposition of silicon compounds.

4. Process according to one of claims 1 through 3, characterized in that one or a plurality of dielectric layer(s) of $SiO_x$ is(are) applied onto the getter layer of amorphous or microcristalline silicon, wherein $1 \leqslant x \leqslant 2$.

5. Process according to one of claims 1 through 3, characterized in that one or a plurality of dielectric layer(s) of $Al_2O_3$ is(are) applied onto the getter layer of amorphous or microcristalline silicon.

6. Process according to one of claims 1 through 3, characterized in that one or a plurality of dielectric layer(s) of $Si_3N_4$ is(are) applied onto the getter layer of amorphous or microcristalline silicon.

7. Process according to one of claims 1 through 3, characterized in that one or a plurality of dielectric layer(s) of MgO, BeO, $ZrO_2$ or $TiO_2$, respectively, is(are) applied onto the getter layer of amorphous or microcristalline silicon.

8. Process according to one of claims 1 through 7, characterized in that in the second step the device is heated, in a suitable gas atmosphere, particularly in $H_2$, $N_2$ or in noble gases, or in vacuum, for a period of time, particularly 10 minutes to 6 hours, to a suitable temperature of, e.g., 200° to 1200° C, preferably to 600° to 900° C.

9. Process according to one of claims 1 through 8, characterized in that in the third step the dielectric layer and the getter layer are removed simultaneously by the action of a suitable gas atmosphere.

10. Process according to one of claims 1 through 8, characterized in that initially the dielectric layer is removed under the influence of a specific etching solution and then the getter layer is removed by means of an acid mixture.

11. Process according to one of claims 1 through 10, characterized in that during the gettering of silicon solar cells the amorphous or microcrystalline silicon getter layer is applied to the front face of the silicon substrate and/or to the p-conductive silicon layer and/or to the n-conductive silicon layer, thereafter a thin dielectric layer is precipitated, then the coated device is subjected to thermal treatment and finally the dielectric layer and the getter layer are removed.

12. Process according to claim 11, characterized in that an amorphous or microcrystalline silicon layer is applied by thermal decomposition of trichlorosilane, then a thin dielectric layer of SiO is precipitated, whereupon the structure is tempered in hydrogen gas for 10 to 120 minutes at temperatures from 600°C to 950°C and finally the dielectric layer and the getter layer are removed.

## Revendications

1. Procédé pour purifier des éléments de semiconducteurs, notamment des éléments de semiconducteurs en silicium, qui inclut la combinaison des étapes opératoires suivantes:

a. dépôt d'une couche de getter réalisée en silicium amorphe ou microcristallin sur la face avant du composant, éventuellement dépôt d'une ou de plusieurs couches diélectriques minces (3 nm-3 µm) sur la couche de getter,

b. traitement thermique du composant recouvert, et

c. enlèvement de la couche de getter, ainsi qu'éventuellement de la ou des couches diélectriques.

2. Procédé selon la revendication 1, caractérisé en ce que, lors de la première étape opératoire, on dépose du silicium amorphe ou microcristallin sur une épaisseur de couche de quelques 10 nm à 10 µm.

3. Procédé selon la revendication 1 ou 2, caractérisé en ce que le dépôt du silicium amorphe ou microcristallin est réalisé au moyen d'un dépôt à partir de la phase vapeur, au moyen de la décomposition-thermique de composés du silicium.

4. Procédé selon l'une des revendications 1 à 3, caractérisé en ce que sur la couche de getter en silicium amorphe ou microcristallin, on dépose une ou plusieurs couches diélectriques de SiO, avec $1 \leqslant x \leqslant 2$.

5. Procédé selon l'une des revendications 1 à 3, caractérisé en ce que sur la couche de getter réalisée en silicium amorphe ou microcristallin, on dépose une ou plusieurs couches diélectriques de $Al_2O_3$.

8. Procédé selon l'une des revendications 1 à 3, caractérisé en ce que, sur la couche de getter réalisée en silicium amorphe ou microcristallin, on dépose une ou plusieurs couches diélectriques de $Si_3N_4$.

7. Procédé selon l'une des revendications 1 à 3, caractérisé en ce que, sur la couche de getter réalisée en silicium amorphe ou microcristallin, on dépose une ou plusieurs couches diélectriques de MgO, BeO, $ZrO_2$ ou $TiO_2$.

8. Procédé selon l'une des revendications 1 à 7, caractérisé en ce que, lors de la seconde étape opératoire, on chauffe le composant dans une atmosphère de gaz appropriée, notamment dans du $H_2$, du $N_2$ ou des gaz rares, ou bien sous vide, pendant quelques temps, notamment entre 10 mn et 6 h, à une température appropriée par exemple de 200 à 1200°C et de préférence de 600 à 900°C.

9. Procédé selon l'une des revendications 1 à 8, caractérisé en ce que, lors de la troisième étape opératoire, on élimine simultanément la couche diélectrique et la couche de getter en faisant agir une atmosphère de gaz appropriée.

10. Procédé selon l'une des revendications 1 à 8, caractérisé en ce que l'on élimine tout d'abord la couche diélectrique en faisant agir une solution corrosive spécifique et qu'on élimine ensuite la couche de getter à l'aide d'un mélange d'acides.

11. Procédé selon l'une des revendications 1 à 10, caractérisé en ce que, lors du dégazage de piles solaires en silicium, on dépose sur la face avant du substrat en silicium et/ou sur la couche de silicium conductrice de type p et/ou sur la couche de silicium conductrice de type n, la couche de getter formée de silicium amorphe ou microcristallin, puis on dépose une couche diélectrique mince, à la suite de quoi on soumet le composant muni de ces couches au traitement thermique et qu'on élimine ensuite la couche diélectrique et la couche de getter.

12. Procédé selon la revendication 11, caractérisé en ce qu'on dépose une couche de silicium amorphe ou monocristallin au moyen de la décomposition thermique de trichlorosilane, qu'on dépose ensuite une couche diélectrique mince constituée par du $SiO_x$, à la suite de quoi on soumet la structure à un recuisson dans une atmosphère d'hydrogène pendant 10 à 120 mn à des températures de 600°C à 950°C et on élimine ensuite la couche diélectrique et la couche de getter.